# EUROPEAN PATENT APPLICATION

(11) **EP 2 801 754 A2**
(43) Date of publication of application: **12.11.2014**
(21) Application number: 13167956.5
(22) Date of filing: 16.05.2013
(51) Int. Cl.: F21V 3/00, F21Y 101/02

(54) **Light-emitting module, light-emitting device, and luminaire**

(30) Priority: 15.02.2013 JP 2013027830
(71) Applicant: Toshiba Lighting & Technology Corporation, Yokosuka-shi Kanagawa 237-8510 (JP)
(72) Inventor: Matsuda, Ryotaro, Kanagawa, 237-8510 (JP); Ishida, Masazumi, Kanagawa, 237-8510 (JP); Kimiya, Junichi, Kanagawa, 237-8510 (JP); Sasaki, Jun, Kanagawa, 237-8510 (JP)
(74) Representative: Bokinge, Ole

(57) **Abstract**

According to one embodiment, a light-emitting module includes a substrate (31), a cover (27), a frame body (28), and a resin layer (29). A light-emitting section (32) including a light-emitting element (33) is provided on the substrate. The cover has translucency and is opposed to the light-emitting section. The frame body is interposed between the substrate and the cover around the light-emitting section. The resin layer has translucency and is interposed between the light-emitting section and the cover while being set in contact with the light-emitting section and the cover.

## Description

### FIELD

Embodiments described herein relate generally to a light-emitting module, a light-emitting device, and a luminaire that emit light.

### BACKGROUND

There has been a luminaire configured by combining a light-emitting device including a light-emitting module and a thermal radiator.

In the light-emitting module, a light-emitting element is mounted on a substrate to form a light-emitting section. The substrate is covered with a translucent cover. The cover is arranged apart from the light-emitting section to be less easily affected by heat from the light-emitting section. An air layer is formed between the light-emitting section and the cover. Light emitted by the light-emitting section is transmitted through the air layer and the cover and irradiated in a lighting space. The heat from the light-emitting section is thermally conducted mainly from the substrate to the thermal radiator and radiated.

However, since the air layer is present between the light-emitting section and the cover as a heat insulating layer, the heat of the light-emitting section cannot be efficiently transferred to the cover. Therefore, the heat radiation from the cover cannot be expected.

Further, a refractive index difference between the light-emitting section and the air layer and a refractive index difference between the air layer and the cover are large. Therefore, a part of light is sometimes reflected in a boundary between the light-emitting section and the air layer and is not emitted from the light-emitting section or a part of light is sometimes reflected on the inner surface of the cover and is not emitted from the cover. This causes deterioration in light extracting efficiency of the light-emitting module.

### BRIEF DESCRIPTION OF THE DRAWINGS

FIG. 1 is a sectional view of a light-emitting module and a light-emitting device according to a first embodiment;
FIG. 2 is a perspective view of the light-emitting module and the light-emitting device;
FIG. 3 is a perspective view of a luminaire in which the light-emitting device is used;
FIG. 4 is a sectional view of a light-emitting module and a light-emitting device according to a second embodiment;
FIG. 5 is a sectional view of a light-emitting module and a light-emitting device according to a third embodiment;
FIG. 6 is a sectional view of a light-emitting module and a light-emitting device according to a fourth embodiment;
FIG. 7 is a sectional view of a light-emitting module and a light-emitting device according to a fifth embodiment;
FIG. 8 is a sectional view of a light-emitting module and a light-emitting device according to a sixth embodiment;
FIG. 9 is a perspective view of a light-emitting module and a light-emitting device according to a seventh embodiment; and
FIG. 10 is a sectional view of the light-emitting device.

### DETAILED DESCRIPTION

In general, according to one embodiment, a light-emitting module includes a substrate, a cover, a frame body, and a resin layer. A light-emitting section including a light-emitting element is provided on the substrate. The cover has translucency and is opposed to the light-emitting section. The frame body is interposed between the substrate and the cover around the light-emitting section. The resin layer has translucency and is interposed between the light-emitting section and the cover while being set in contact with the light-emitting section and the cover.

In the light-emitting module, the resin layer is interposed between the light-emitting section and the cover while being set in contact with the light-emitting section and the cover. Therefore, it can be expected that heat of the light-emitting section can be efficiently transferred to the cover and heat dissipation are improved. Further, it can be expected that light of the light-emitting section can be efficiently made incident on the cover and light extracting efficiency is improved.

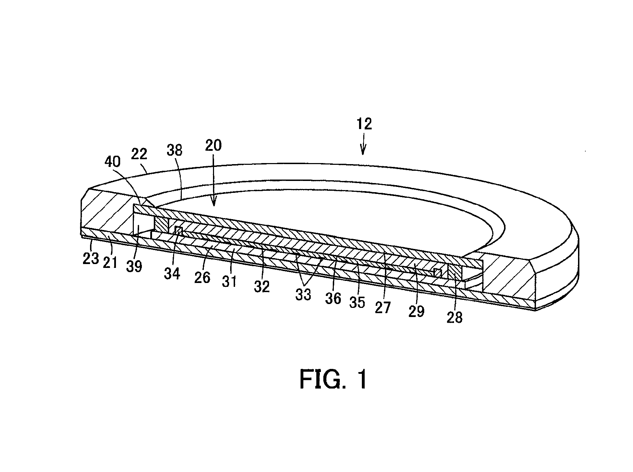

A first embodiment is explained below with reference to FIGS. 1 to 3.

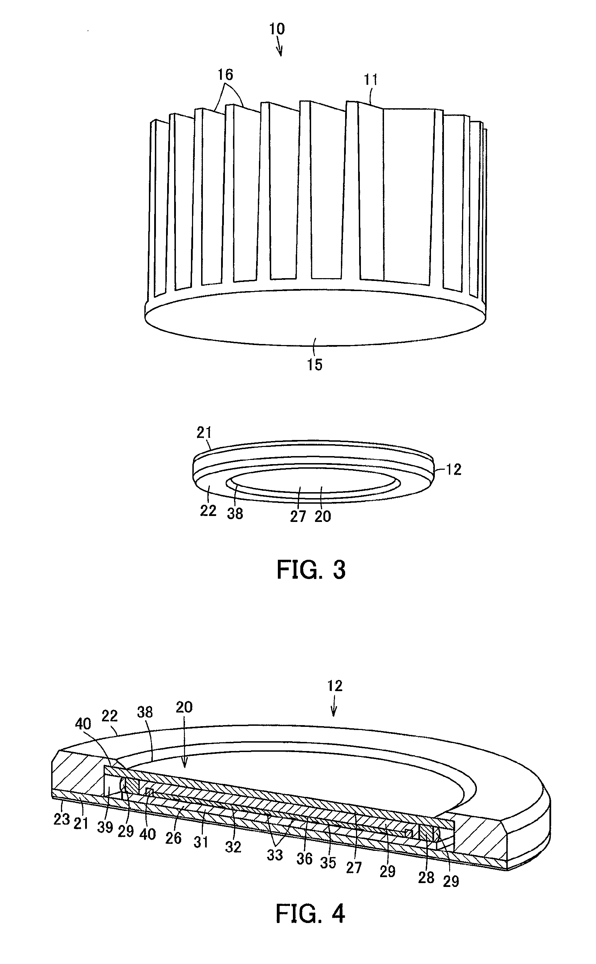

A luminaire is shown in FIG. 3. A luminaire 10 includes a thermal radiator 11 and a light-emitting device 12 detachably attached to the thermal radiator 11.

The thermal radiator 11 configures a part of a luminaire main body set on the ceiling or the like. The thermal radiator 11 is formed of a metal material such as aluminum. A planar attachment surface 15 to which the light-emitting device 12 is attached in a thermally connected state is formed on the lower surface of the thermal radiator 11. A plurality of thermal radiation fins 16 are protrudingly provided on the upper surface of the thermal radiator 11.

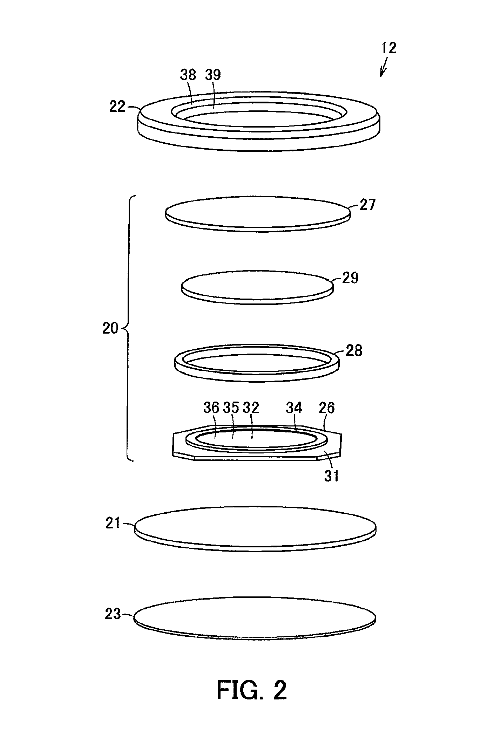

As shown in FIGS. 1 and 2, the light-emitting device 12 includes a light-emitting module 20, a thermal radiation plate 21 to which the light-emitting module 20 is thermally connected, a case 22 that houses the light-emitting module 20, and a thermal radiation sheet 23 attached to the thermal radiation plate 21.

The light-emitting module 20 includes a luminous element 26, a cover 27 that covers the luminous element 26, a frame body 28 interposed between the luminous element 26 and the cover 27, and a resin layer 29 densely formed among the luminous element 26, the cover 27, and the frame body 28.

The luminous element 26 includes a substrate 31 and a light-emitting section 32 provided on a mounting surface, which is one surface (the front surface) of the substrate 31. The substrate 31 is formed of a material excellent in heat conductivity such as metal, ceramics, or resin and in a flat shape. A wiring pattern is formed on the mounting surface. If the substrate 31 is metal, an insulating layer is formed between the substrate 31 and the wiring pattern.

The light-emitting section 32 includes a plurality of light-emitting elements 33 mounted on the substrate 31, a wall section 34 surrounding the plurality of light-emitting elements 33, and sealing resin 35 for integrally sealing the plurality of light-emitting elements 33 on the inner side of the wall section 34. That is, a COB (Chip On Board) system is adopted for the light-emitting section 32. The surface of the sealing resin 35 is formed as a circular light-emitting surface 36. LED elements that emit blue light are used as the light-emitting elements 33. A rein material having translucency such as silicone resin containing a phosphor excited by the blue light to emit yellow light is used for the sealing resin 35. An optical output of the light-emitting section 32 is high power equal to or larger than 2000 Im. As the light-emitting element, an SMD (Surface Mount Device) package may be used. The light-emitting element is not limited to the LED element. An EL (Electro Luminescence) element or the like may be used.

The cover 27 has translucency for visible light. The cover 27 is formed of a material such as resin, glass, or ceramics having a heat resistance temperature equal to or higher than 100°C and in a flat disk shape larger in diameter than the light-emitting section 32 and the substrate 31.

The frame body 28 is formed of a resin material such as silicone resin or a metal material such as a spring member having elasticity and in an annular shape larger in diameter than the light-emitting section 32 and smaller in diameter than the substrate 31. The frame body 28 is arranged around the light-emitting section 32 on the mounting surface of the substrate 31. The frame body 28 is interposed between the substrate 31 and the cover 27 and set in contact with each of the substrate 31 and the cover 27. A space is kept between the substrate 31 and the cover 27.

The resin layer 29 is formed of a transparent rein material such as silicone resin and to prevent an air layer from being present among the substrate 31 of the luminous element 26 and the light-emitting section 32, the cover 27, and the frame body 28. That is, the resin layer 29 is closely attached to each of the light-emitting section 32 and the cover 27. It is desirable to select the materials to set a refractive index difference between the resin layer 29 and the sealing resin 35 of the light-emitting section 32 and a refractive index difference between the resin layer 29 and the cover 27 within 0 to 0.2. As a method of forming the resin layer 29, the resin material not hardened yet and having fluidity is filled on the light-emitting section 32 on the inner side of the frame body 28, the cover 27 is pressed against and closely attached to the resin material, and thereafter the resin material is hardened to form the resin layer 29. The resin layer 29 only has to be formed at least between the light-emitting section 32 and the cover 27.

When the hardness of the cover 27 is represented as h1, the hardness of the frame body 28 is represented as h2, the hardness of the sealing resin 35 is represented as h3, and the hardness of the resin layer 29 is represented as h4, there is a relation h1≥h2≥h3≥h4 (a more desirable relation is h1>h2>h3>h4). That is, the hardness h2 of the frame body 28 is equal to or higher than the hardness h4 of the resin layer 29. The hardness h1 of the cover 27 is equal to or higher than the hardness h4 of the resin layer 29. The hardness h1 of the cover 27 is equal to or higher than the hardness h2 of the frame body 28. The hardness h3 of the sealing resin 35 is equal to or higher than the hardness h4 of the resin layer 29.

The thermal radiation plate 21 is, for example, a heat spreader. The thermal radiation plate 21 is formed in a flat disk shape larger in diameter than the substrate 31 and the cover 27. The rear surface of the substrate 31 on the opposite side of the mounting surface is set in contact with one surface of the thermal radiation plate 21.

The case 22 is formed of, for example, a resin material. A circular opening section 38 is formed on the front surface, which is one surface, of the case 22. A circular housing section 39 for housing the light-emitting module 20 between the case 22 and the thermal radiation plate 21 is opened on the rear surface on the opposite side of the front surface. The diameter of the opening section 38 is smaller than the diameter of the housing section 39. A step section 40 is formed between the opening section 38 and the housing section 39. The diameter of the opening section 38 is formed in a dimension smaller than the diameter of the cover 27.

The thermal radiation sheet 23 is formed of a material excellent in heat conductivity.

The light-emitting module 20 is housed in the housing section 39 of the case 22, the cover 27 is set in contact with the step section 40, and the light-emitting module 20 is placed and held between the step section 40 and the thermal radiation plate 21 to form the light-emitting device 12.

As shown in FIG. 3, the thermal radiation plate 21 of the light-emitting device 12 is attached to the attachment surface 15 of the thermal radiator 11 via the thermal radiation sheet 23 while being in surface contact with the attachment surface 15. A power supply device is arranged on the side of a luminaire main body including the thermal radiator 11. The power supply device and the light-emitting device 12 are electrically connected by connecting means. Electric power for causing the plurality of light-emitting elements 33 to emit light is supplied from the power supply device to the light-emitting module 20.

When the plurality of light-emitting elements 33 of the light-emitting device 12 emit light, light emitted from the light-emitting surface 36 of the light-emitting section 32 is made incident on the resin layer 29, transmitted through the resin layer 29 and made incident on the cover 27, and radiated to a lighting space from the front surface of the cover 27. The resin layer 29 is densely formed between the light-emitting section 32 and the cover 27. An air layer is not interposed between the light-emitting section 32 and the cover 27. A refractive index difference between the sealing resin 35 of the light-emitting section 32 and the resin layer 29 and a refractive index difference between the resin layer 29 and the cover 27 decrease. Therefore, reflection of the light in a boundary between the sealing resin 35 of the light-emitting section 32 and the resin layer 29 decreases and reflection of the light in a boundary between the resin layer 29 and the cover 27 decreases. The light is easily made incident in the resin layer 29 from the sealing resin 35 of the light-emitting section 32 and easily made incident on the cover 27 from the resin layer 29. Therefore, the light emitted from the front surface of the cover 27 increases and the light extracting efficiency of the light-emitting module 20 is improved.

A part of heat generated by the plurality of light-emitting elements 33 is thermally conducted to the thermal radiator 11 through the substrate 31, the thermal radiation plate 21, and the thermal radiation sheet 23 and radiated to the atmosphere from the thermal radiator 11.

Further, a part of the heat generated by the plurality of light-emitting elements 33 is conducted to the resin layer 29 from the sealing resin 35, the wall section 34, and the substrate 31, conducted to the cover 27 from the resin layer 29, and radiated to the atmosphere from the front surface of the cover 27. Therefore, it is possible to efficiently transfer the heat of the light-emitting section 32 to the cover 27 and improve heat dissipation.

Since the hardness h2 of the frame body 28 is equal to or higher than the hardness h4 of the resin layer 29, even if an external force is applied to the front surface of the cover 27, the cover 27 is supported by the frame body 28 and the external force is absorbed by the resin layer 29. Therefore, it is possible to reduce the external force applied to the light-emitting section 32.

Since the hardness h1 of the cover 27 is equal to or higher than the hardness h4 of the resin layer 29, even if an external force is applied to the front surface of the cover 27, the cover 27 is robust against the external force and the external force is absorbed by the resin layer 29. Therefore, it is possible to reduce a load on the light-emitting section 32.

Since the hardness h1 of the cover 27 is equal to or higher than the hardness h2 of the frame body 28, even if an external force is applied to the front surface of the cover 27, the cover 27 is robust against the external force. Therefore, it is possible to reduce a load on the light-emitting section 32.

Since the hardness h3 of the sealing resin 35 is equal to or higher than the hardness h4 of the resin layer 29, even if an external force is applied to the front surface of the cover 27, the external force is absorbed by the resin layer 29 and the sealing resin 35 is robust against the external force. Therefore, it is possible to reduce a load on the light-emitting section 32.

Since the dimension of the opening section 38 of the case 22 is smaller than the external shape of the cover 27, even if the cover 27 comes off the light-emitting module 20, it is possible to prevent the cover 27 from dropping out from the opening section 38 of the case 22.

If the cover 27 is glass, since the resin layer 29 adheres to the glass, even if the glass is, for example, dropped and broken during handling of the light-emitting device 12, it is possible to prevent the glass from scattering.

A second embodiment is shown in FIG. 4. Components same as those in the first embodiment are denoted by the same reference numerals. Explanation of the components and the action and effect of the components is omitted.

A part of the resin material of the resin layer 29 filled between the light-emitting section 32 and the cover 27 extends to the outer side of the frame body 28 and is bonded to the substrate 31 and the cover 27. That is, if a filling amount of the resin material not hardened yet and having fluidity filled on the light-emitting section 32 on the inner side of the frame body 28 is increased and the cover 27 is pressed against and closely attached to the resin material, a part of the resin material extends to the outer side of the frame body 28. Consequently, a part of the resin material of the resin layer 29 extends to the outer side of the frame body 28 and is bonded to the substrate 31 and the cover 27.

Since a part of the resin material of the resin layer 29 extends to the outer side of the frame body 28 in this way, the frame body 28 can be firmly fixed to the substrate 31 and the cover 27. Moreover, when a part of the resin material of the resin layer 29 extends to the outer side of the frame body 28, air bubbles can be squeezed out to the outer side of the frame body 28 together with the resin material. Therefore, it is possible to reduce the air bubbles remaining between the light-emitting section 32 and the cover 27.

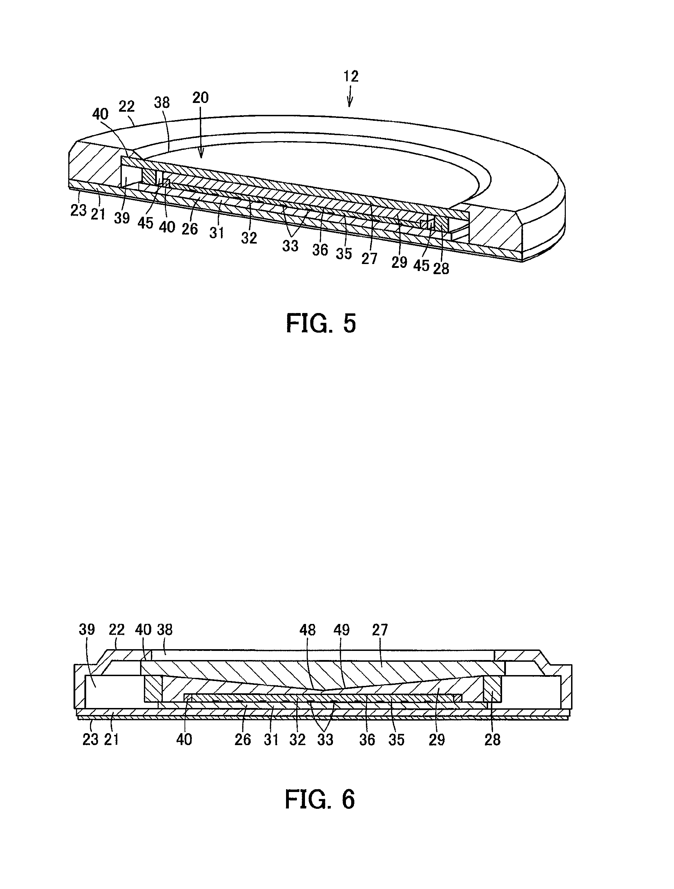

A third embodiment is shown in FIG. 5. Components same as those in the embodiments explained above are denoted by the same reference numerals. Explanation of the components and the action and effect of the components is omitted.

A gap 45 is formed between the resin layer 29, which is filled between the light-emitting section 32 and the cover 27, and the frame body 28.

When an external force is applied to the front surface of the cover 27, the resin layer 29 crushed and deformed between the cover 27 and the light-emitting section 32 is enabled to escape to the gap 45. Therefore, it is possible to make it easy to absorb the external force in the resin layer 29 and reduce the external force applied to the light-emitting section 32.

A fourth embodiment is shown in FIG. 6. Components same as those in the embodiments explained above are denoted by the same reference numerals. Explanation of the components and the action and effect of the components is omitted.

A projecting section 48 projecting to the resin layer 29 side is provided on the rear surface of the cover 27 on the opposite side of the front surface. The projecting section 48 is formed by a conical section 49 projecting to the center of the rear surface of the cover 27. Therefore, the cover 27 is formed to be reduced in thickness from the center toward the peripheral portion of the cover 27.

If the resin material not hardened yet and having fluidity is filled on the light-emitting section 32 on the inner side of the frame body 28 and the cover 27 is pressed against and closely attached to the resin material, first, the tip of the conical section 49 comes into contact with the resin material. Thereafter, the contact with the resin material shifts from the tip to the peripheral portion of the conical section 49. The air between the conical section 49 and the resin material is squeezed out to the peripheral portion of the conical section 49.

Therefore, the air less easily remains between the cover 27 and the resin layer 29. The cover 27 and the resin layer 29 adhere to each other. Therefore, it is possible to contribute to improvement of the light extracting efficiency and improvement of the heat conductivity.

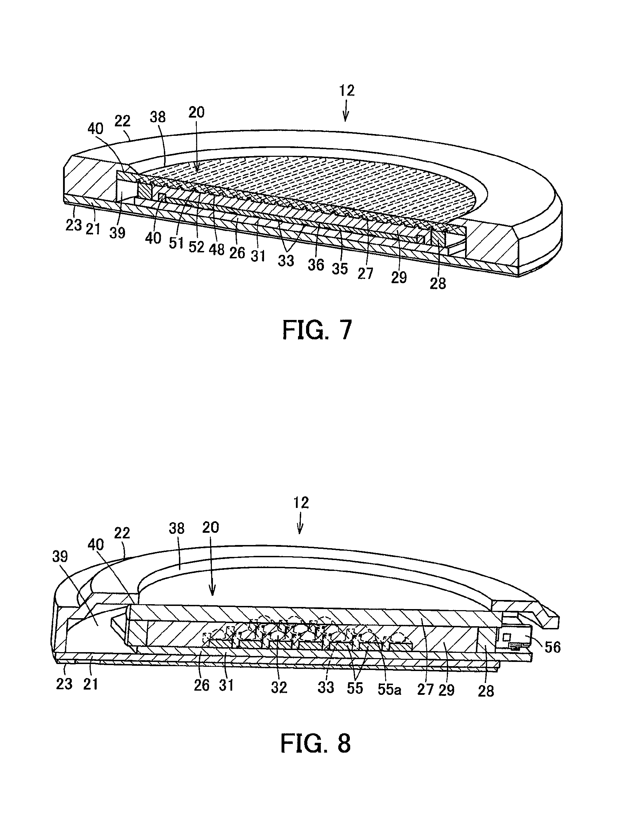

A fifth embodiment is shown in FIG. 7. Components same as those in the embodiments explained above are denoted by the same reference numerals. Explanation of the components and the action and effect of the components is omitted.

The projecting section 48 projecting to the resin layer 29 side is provided on the rear surface of the cover 27. A plurality of grooves 51 are formed in parallel on the rear surface of the cover 27, whereby the projecting section 48 is formed by a plurality of ridges 52 projecting among the plurality of grooves 51. The depth of the grooves 51 is, for example, 0.3 to 0.6 mm.

The rear surface of the cover 27, to which the resin layer 29 adheres, is formed in an uneven shape. Therefore, it is possible to strengthen the joining of the cover 27 and the resin layer 29, improve the drop prevention effect for the cover 27, and, if the cover 27 is glass, improve the scattering prevention effect when the glass is broken.

A sixth embodiment is shown in FIG. 8. Components same as those in the embodiments explained above are denoted by the same reference numerals. Explanation of the components and the action and effect of the components is omitted.

A plurality of SMD packages 55 are used as the light-emitting elements 33 of the luminous element 26. The plurality of SMD packages 55 are mounted on the mounting surface of the substrate 31. The light-emitting section 32 is formed by the plurality of SMD packages 55. The plurality of SMD packages 55 are projected from the mounting surface of the substrate 31.

An LED element is arranged in the SMD package 55. A dome-like light-emitting surface 55a, from which light is emitted, is formed on the front surface of the SMD package 55.

To form the resin layer 29, the rear surface of the cover 27 is turned upward and the frame body 28 is formed on the rear surface. The rein material not hardened yet and having fluidity is filled in the inner side of the frame body 28. The luminous element 26 is pressed on the frame body 28 to submerge the plurality of SMD packages 55 in the resin material. The resin material is hardened to form the resin layer 29. At this point, since the plurality of SMD packages 55 project, the air is easily squeezed out at least from between the light-emitting surfaces 55a and the resin material. Therefore, the air less easily remains between the light-emitting surfaces 55a of the plurality of SMD packages 55 and the resin layer 29. The light-emitting surfaces 55a of the plurality of SMD packages 55 and the resin layer 29 adhere to each other. Consequently, it is possible to contribute to improvement of the light extracting efficiency and improvement of the heat conductivity.

A connector 56 electrically connected to the plurality of SMD packages 55 through a wiring pattern is mounted on the mounting surface of the substrate 31. The connector 56 is exposed to the outside from a cutout portion on the side surface of the case 22 in a state in which the light-emitting module 20 is housed in the case 22. A cable can be connected to the connector 56 from a power supply circuit of the luminaire 10.

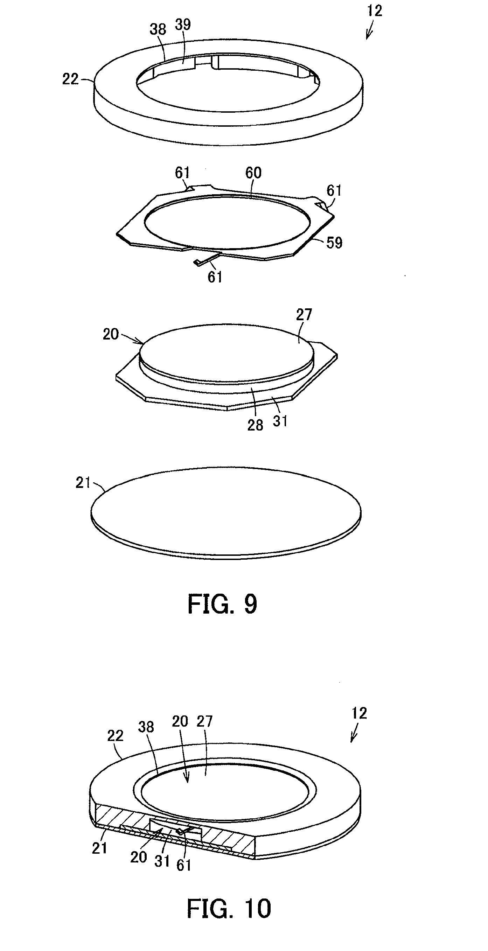

A seventh embodiment is shown in FIGS. 9 and 10. Components same as those in the embodiments explained above are denoted by the same reference numerals. Explanation of the components and the action and effect of the components is omitted.

A pressing member 59 that presses the substrate 31 of the light-emitting module 20 against the thermal radiation plate 21 is arranged between the thermal radiation plate 21 and the case 22 together with the light-emitting module 20.

The pressing member 59 is formed of a leaf spring material. A circular opening section 60 smaller than the diameter of the cover 27 is formed in the center of the pressing member 59. A plurality of pressing sections 61 projecting toward the substrate 31 side are provided in the peripheral portion of the pressing member 59. The pressing member 59 is fit and fixed in the housing section 39 of the case 22.

The light-emitting module 20 is housed in the housing section 39 of the case 22 in which the pressing member 59 is fixed. The light-emitting module 20 is placed between the case 22 and the thermal radiation plate 21. At this point, the plurality of pressing sections 61 of the pressing member 59 come into contact with the substrate 31 to press the substrate 31 against the thermal radiation plate 21 and hold the substrate 31. Consequently, it is possible to improve adhesion of the substrate 31 and the thermal radiation plate 21, improve the heat conductivity, and improve the heat dissipation.

Since the dimension of the opening section 60 of the pressing member 59 is smaller than the external shape of the cover 27, even if the cover 27 comes off the light-emitting module 20, it is possible to prevent the cover 27 from dropping out from the opening section 60 of the pressing member 59. Since the pressing member 59 is fixed to the case 22, the opening section 60 of the pressing member 59 is equivalent to the opening section 38 of the case 22. Therefore, it is possible to prevent the cover 27 from dropping out from the opening section 38 of the case 22.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments described herein may be made without departing from the spirit of the inventions. The accompanying claims and their equivalents are intended to cover such forms or modifications as would fall within the scope and spirit of the inventions.

## Claims

1. A light-emitting module comprising:
a substrate (31) on which a light-emitting section (32) including a light-emitting element (33) is provided;
a cover (27) having translucency and opposed to the light-emitting section (32);
a frame body (28) interposed between the substrate (31) and the cover (27) around the light-emitting section (32); and
a resin layer (29) having translucency and interposed between the light-emitting section (32) and the cover (27) while being set in contact with the light-emitting section (32) and the cover (27).

2. The module according to claim 1, wherein hardness of the frame body (28) is equal to or higher than hardness of the resin layer (29).

3. The module according to claim 1 or 2, wherein hardness of the cover (27) is equal to or higher than hardness of the resin layer (29).

4. The module according to any one of claims 1 to 3, wherein hardness of the cover (27) is equal to or higher than hardness of the frame body (28).

5. The module according to any one of claims 1 to 4, wherein
the light-emitting section (32) includes the light-emitting element (33) mounted on the substrate (31) and sealing resin (35) that covers the light-emitting element (33), and
hardness of the sealing resin (35) is equal to or higher than hardness of the resin layer (29).

6. The module according to any one of claims 1 to 5, wherein the cover (27) includes a projecting section (48) projecting to the resin layer (29) side.

7. The module according to any one of claims 1 to 6, wherein a part of the resin layer (29) extends to an outer side of the frame body (28).

8. The module according to any one of claims 1 to 6, wherein a gap (45) is formed between the frame body (28) and the resin layer (29).

9. A light-emitting device comprising:
the light-emitting module (20) according to any one of claims 1 to 8;
a thermal radiation plate (21) on which the substrate (31) is arranged;
a case (22) including an opening section (38) opposed to the cover (27), the light-emitting module (20) being arranged between the case (22) and the thermal radiation plate (21); and
a pressing member (59) configured to press the substrate (31) on the thermal radiation plate (21).

10. A light-emitting device comprising:
the light-emitting module (20) according to any one of claims 1 to 8;
a thermal radiation plate (21) on which the substrate (31) is arranged;
a case (22) including an opening section (38) that is smaller than an external shape of the cover (27) and is opposed to the cover (27), the light-emitting module (20) being arranged between the case (22) and the thermal radiation plate (21).

11. A luminaire comprising:
a thermal radiator (11); and
the light-emitting device (12) according to claim 9 or 10 attached to set the thermal radiation plate (21) in contact with the thermal radiator (11).
